# EUROPÄISCHE PATENTSCHRIFT

(11) **EP 0 506 693 B1**
(45) Veröffentlichungstag und Bekanntmachung des Hinweises auf die Patenterteilung: **05.04.1995**
(21) Anmeldenummer: 91900199.0
(22) Anmeldetag: 14.12.1990
(51) Int. Cl.: H03H 9/64, H03H 9/02

(54) **OBERFLÄCHENWELLEN-REFLEKTORFILTER**
SURFACE WAVE REFLECTOR FILTER
FILTRE-REFLECTEUR D'ONDES SUPERFICIELLES

(30) Priorität: 20.12.1989 DE 3942140
(43) Veröffentlichungstag der Anmeldung: 07.10.1992
(73) Patentinhaber: SIEMENS AKTIENGESELLSCHAFT, 80333 München (DE)
(72) Erfinder: RUILE, Werner, D-8000 München 19 (DE); VISINTINI, Giuliano Dr., D-8025 Unterhaching (DE); MACHUI, Jürgen, D-8000 München 40 (DE)
(86) Internationale Anmeldenummer: EP9002193
(87) Internationale Veröffentlichungsnummer: WO9109465

(56) Entgegenhaltungen:
- PATENT ABSTRACTS OF JAPAN, Vol. 10, No. 363 (E-461)(2420), 5. Dezember 1986
- PROCEEDINGS OF THE INSTITUTE OF ELECTRICAL AND ELECTRONIC ENGINEERS; Vol. 63, No. 6, June 1975, (New York,US). S. Pookaiyaudom et al.: "Electromagnetic leakage suppression by interdigital transducers", page 990

## Beschreibung

Die vorliegende Erfindung bezieht sich auf ein mit akustischen Oberflächenwellen arbeitendes Reflektorfilter mit einem Eingangswandler, einem Ausgangswandler und mit einer Reflektorstruktur. Das Signal soll vom Eingangswandler zum Ausgangswandler auf akustischem Wege über die Reflektorstruktur laufen, um die notwendige Filtereigenschaft zu erzielen. Direkter Signalübergang zwischen dem Eingangswandler und dem Ausgangswandler ist ein unerwünschtes Übersprechen, das möglichst vollständig zu verhindern ist. Bekannte Lösungen dieses Problems sind, den Eingangswandler und den Ausgangswandler auf dem Substrat des Filters so anzuordnen, daß dieser direkte akustische Signalübergang vom Eingang zum Ausgang ausgeschlossen ist. Das Gegenteil ist bei einem Resonatorfilter der Fall.

Aus den Druckschriften US-A-4 484 160 und 4 520 330 sind als RAC-Filter bezeichnete Reflektor-Oberflächenwellenfilter bekannt. Eine Ausführungsform weist einen Eingangswandler und einen Ausgangswandler und zwei Reflektorstrukturen auf, die derart schräggestellt Reflektorfinger haben, daß eine in den einen Reflektor hineinlaufende akustische Welle um etwa 90° umlenkt in den anderen Reflektor gelangt und von diesem wiederum um 90° abgelenkt dem Ausgangswandler zugeführt wird. Ein solches Filter eignet sich als breitbandiges Filter für die Verwendung als Zeitfenster. Die Fingerstrukturen der erwähnten Reflektoren können der gewünschten Übertragungsfunktion entsprechend gewichtet und/oder dispersiv sein. Als Fingerwichtung kann insbesondere Fingerverschiebungswichtung, Fingerweglaßwichtung und Fingerdrehung vorgesehen sein. Ein solches bekanntes Reflektorfilter hat zwei akustische Spuren und Eingangswandler und Ausgangswandler liegen in je einer der beiden Spuren. Ein solches Filter erfordert infolge des gefalteten akustischen Weges eine geringere Länge des Substrats, was erhebliche Einsparungen mit sich bringt. Ein wie bekanntes RAC-Filter hat jedoch einen gewissen Nachteil, daß die Winkelgenauigkeit der Reflexion temperaturabhängig ist, und zwar dies auch bei einem Substrat aus Quarz.

In IEEE Trans. Ultrasonics Bd. 35 (1988) Seiten 61 ff. sind weitere Ausführungsformen für mehrspurige Reflektorfilter mit Multistripkopplern angegeben. Der Multistripkoppler erfordert ein Substrat mit hohem elektroakustischem Kopplungsfaktor. Solche Substrate sind jedoch in ihren Eigenschaften der Wellenausbreitung relativ stark temperaturabhängig. Hinzu kommt, daß Multistripkoppler verlustbehaftet sind und auch die Berechnung des Verhaltens eines solchen Filters erschweren.

Ein für die nachfolgend zu beschreibende Erfindung nur scheinbar relevanter Stand der Technik mit in zwei Spuren angeordneten Oberflächenwellenfiltern mit Reflektoren mit 180° Reflexion ist aus "Patent Abstracts of Japan", Bd. 10, Nr. 363 (E-462) (2429) S. 1286 bekannt. Dort ist jedoch in jeder der Spuren ein selbstständiges Filter realisiert. Das eine ist ein Resonatorfilter als Bestandteil eines Oszillators und das andere das Ausgangsfilter der ganzen Schaltung. Keine der beiden Oberflächenwellenanordnungen ist ein wie bei der Erfindung vorgesehenes Reflektorfilter mit nur über den Reflektor vorgesehener Nutzsignal-Übertragung der Signalfrequenz.

Aufgabe der vorliegenden Erfindung ist es, ein mit akustischen Oberflächenwellen arbeitendes Reflektorfilter anzugeben, das bei, bezogen auf die vorgegebenen Anforderungen bezüglich Selektivität, möglichst geringer Größe des notwendigen Substratkörpers ein Optimum an Temperaturunabhängigkeit seiner Eigenschaften, eingeschlossen die Reflexion, aufweist und gegebenenfalls dabei auch ein Minimum an Verlust an Signalenergie (low loss) hat. Das Filter soll dabei nur möglichst geringes akustisches Übersprechen haben.

Diese Aufgabe wird mit einem mit akustischen Oberflächenwellen arbeitenden Reflektorfilter gelöst, das die im Anspruch 1 angegebenen Merkmale hat. Weitere vorteilhafte Ausgestaltungen eines solchen Filters gehen aus den Unteransprüchen hervor.

Unter "Oberflächenwellen" sind im Sinne der Erfindung in bzw. nahe der Oberfläche eines Festkörpers (Substrats) verlaufende akustische Wellen zu verstehen, die genauer spezifiziert als Rayleighwellen, Bleusteinwellen, SSBW-Wellen (surface skimming bulk waves) und dlg. bezeichnet werden und deren jeweiliges Auftreten eine Frage der Orientierung der Kristallrichtung des Substrats in Bezug auf die Anordnung der Oberflächenwellen-Strukturen ist.

Der vorliegenden Erfindung liegt der Gedanke zugrunde, das Filter in in-line-Anordnung, d. h. mit 180° Rückreflexion im Reflektor, auszuführen und das dabei unvermeidlich auftretende Übersprechen durch "direkten" akustischen Signalübergang zwischen Eingangswandler und Ausgangswandler auf besondere Weise zu beheben. Die Lösung, dieses Übersprechen im Ergebnis auszuschließen, wurde in Maßnahmen zur Kompensation desselben gefunden. Ein erfindungsgemäßes Filter besteht aus einem ohne Rücksicht auf Auftreten des direkten akustischen Übersprechens konzipierten in-line-Reflektorfilter, dem eine Kompensationsanordnung zugeordnet ist. Diese Kompensationsanordnung kann mit dem in-line-Filter auf ein und demselben Substrat angeordnet sein, so daß sich damit im Prinzip eine Zweispur-Ausführung ergibt. Diese Kompensationsanordnung kann aber auch auf einem davon getrennten Substrat realisiert sein, da zwischen dem eigentlichen in-line-Filter und der Kompensationsanordnung zur Lösung der der Erfindung gestellten Aufgabe nur elektrisches Zusammenwirken erforderlich ist. Für ein erfindungsgemäßes Filter das nötige Design zu schaffen ist einfacher als dies für ein RAC-Filter der Fall ist.
- Fig. 1: zeigt eine Ausführungsform der Erfindung, an der auch das Prinzip der Erfindung erläutert wird,
- Fig. 2: zeigt im Ausschnitt einen Filter mit akustischer Phasenumkehr durch Polung der Finger,
- Fig. 3: zeigt ein Beispiel einer solchen Phasenumkehr durch veränderten Abstand,
- Fig. 4: zeigt ein Prinzipbild zu einer Ausführung mit kompensierendem Filteranteil auf einem getrennten Substrat,
- Fig. 5: zeigt eine Ausführung mit zwei Reflektoren in einer Spur und
- Fig. 6: zeigt eine Ausführung mit je einem Reflektor in den beiden kompensierten Filteranteilen.

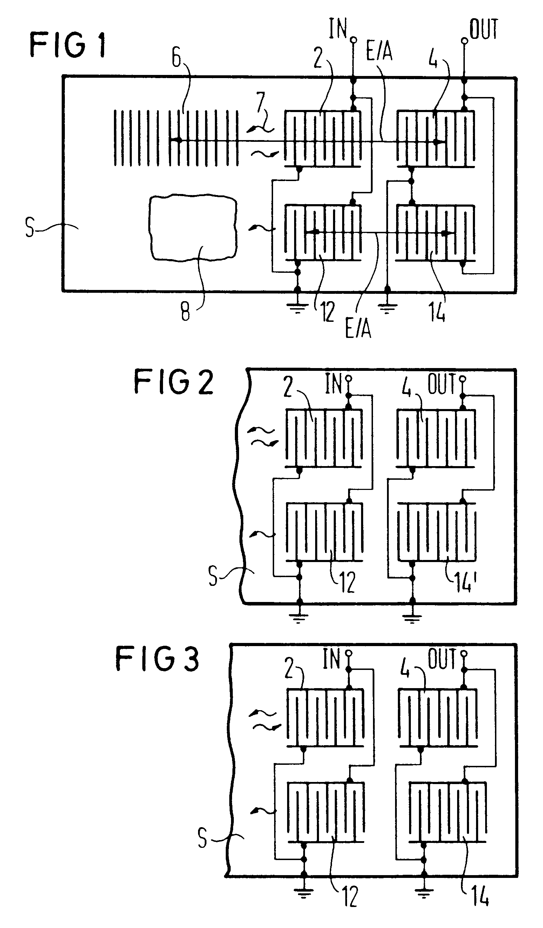

Mit S ist in Fig. 1 der äußere Umriß des Substrats des Filters angedeutet. Auf der Oberfläche des Substrats ist mit 2 bezeichnet ein Interdigitalwandler als Eingangswandler angeordnet. Mit 4 ist ein entsprechender Ausgangswandler bezeichnet. Eingangswandler 2 und Ausgangswandler 4 haben eine zusammenfallende Hauptausbreitungsrichtung E/A der akustischen Welle, die die in-line-Achse bestimmt. Auf der Achse der Hauptausbreitungsrichtung E/A ist die mit 6 bezeichnete Reflektorstruktur vorhanden und mit 7 ist der Hin- und Herweg der akustischen Welle zwischen dem Eingangswandler 2 und dem Reflektor 6 einerseits und dem Reflektor 6 und dem Ausgangswandler 4 andererseits bezeichnet, wobei im letzteren Falle die Welle durch den Wandler 2 hindurch in den Wandler 4 gelangt. Mit der die Teile 2, 4 und 6 umfassenden Filteranordnung läßt sich ein Eingangssignal durch die Reflektorstruktur 6 hindurch in den Ausgangswandler 4 übertragen, wobei das zugehörige Ausgangssignal der Filtercharakteristik der Reflektorstruktur entspricht.

Die soweit beschriebene Anordnung weist den Nachteil auf, daß eine erhebliche direkte Signalübertragung, und zwar auf akustischem Wege, d.h. über eine akustische Welle, zwischen dem Eingangswandler 2 und dem Ausgangswandler 4 vorliegt. Dieser als Übersprechen bezeichnete Anteil im Ausgangssignal des Ausgangswandlers 4 darf aber nicht auftreten. Um dies zu erreichen ist erfindungsgemäß vorgesehen, einen weiteren Eingangswandler 12 und einen weiteren Ausgangswandler 14, und zwar beim Ausführungsbeispiel der Fig. 1 ebenfalls auf dem Substrat S, vorzusehen, wie dies die Figur zeigt. Zusätzlich, aber nicht unumgänglich erforderlich, ist auf der Oberfläche des Substrats S eine als akustischer Sumpf wirkende Oberflächenbeschichtung 8 vorgesehen. Eine von dem Wandler 12 in diesen Sumpf 8 hineinlaufende akustische Welle wird dort derart gedämpft, daß von dort kein nennenswertes akustisches Signal in den Ausgangswandler 14 gelangen kann. Das bedeutet, daß der Ausgangswandler 14 nur dasjenige Ausgangssignal liefert, das durch wie schon oben beschriebene, an sich unerwünschte direkte akustische Übertragung vom Eingangswandler 12 in den Ausgangswandler 14 gelangt.

Erfindungsgemäß ist vorgesehen, daß die Eingangswandler 2 und 12 einerseits und die Ausgangswandler 4 und 14 andererseits jeweils identisch ausgeführte Wandler sind. Damit ist gewährleistet, daß dieses an sich unerwünschte, direkte akustische Übersprechen zu Übersprechsignalen gleicher Amplitude im Ausgangswandler 4 und im Ausgangswandler 14 führt. Weiter ist erfindungsgemäß vorgesehen, diejenigen Maßnahmen zu treffen, die dazu führen, daß das direkte Übersprechen zwischen den Wandlern 2 und 4 des einen Wandlersystems einerseits und zwischen den Wandlern 12 und 14 des anderen Wandlersystems andererseits zu an den Ausgangsanschlüssen der beiden Wandlersysteme phasenentgegengesetzten Übersprech-Signalen führt. Werden also die Ausgangsanschlüsse dieser beiden Ausgangswandler 4 und 14 elektrisch parallel geschaltet, kompensieren sich erfindungsgemäß die auf direktem akustischem Übersprechen beruhrenden Signalanteile im resultierenden Ausgangssignal und der Ausgangswandler 4 liefert nur noch das über die Reflektorstruktur 6 übertragene Signal am Ausgangsanschluß.

Die Fig. 1 zeigt zwei Wandler 2 und 12, die nicht nur der Struktur nach, sondern auch ihrer Anordnung nach miteinander identisch sind. Die Wandler 4 und 14 sind ebenfallls der Struktur nach identisch, jedoch (bei der in der Fig. 1 angegebenen elektrischen Verbindung) miteinander phasenentgegengesetzt zusammengeschaltet.

Der in Fig. 2 gezeigte Ausschnitt gibt eine "akustische" Umkehrung der Phase für den Wandler 14′, nämlich mit phasenentgegengesetztem erstem Finger, wieder. Eine vom Wandler 12 zu dem Wandler 14′ hinüberlaufende akustische Welle erzeugt im Wandler 14′ ein Ausgangssignal, das phasenentgegengesetzt zur Übertragung zwischen den Wandlern 2 und 4 ist.

Ein entsprechender Phasensprung läßt sich weiterhin, wie Fig. 3 zeigt erreichen, nämlich wenn man den Abstand zwischen den Wandlern 2 und 4 einerseits und den Wandlern 12 und 14 andererseits um ein ungradzahlig Vielfaches von Lambda/halbe unterschiedlich groß macht, und zwar bei ansonsten wie in Fig. 1 identisch ausgeführten und angeordneten Wandlern 4 und 14. Dieser um ein ungradzahliges Vielfaches der halben Wellenlänge längere Weg führt ebenfalls zu phasenentgegengesetztem Signal im Wandler 14 und damit zu wie erfindungsgemäßer Kompensation des akustischen Übersprechens.

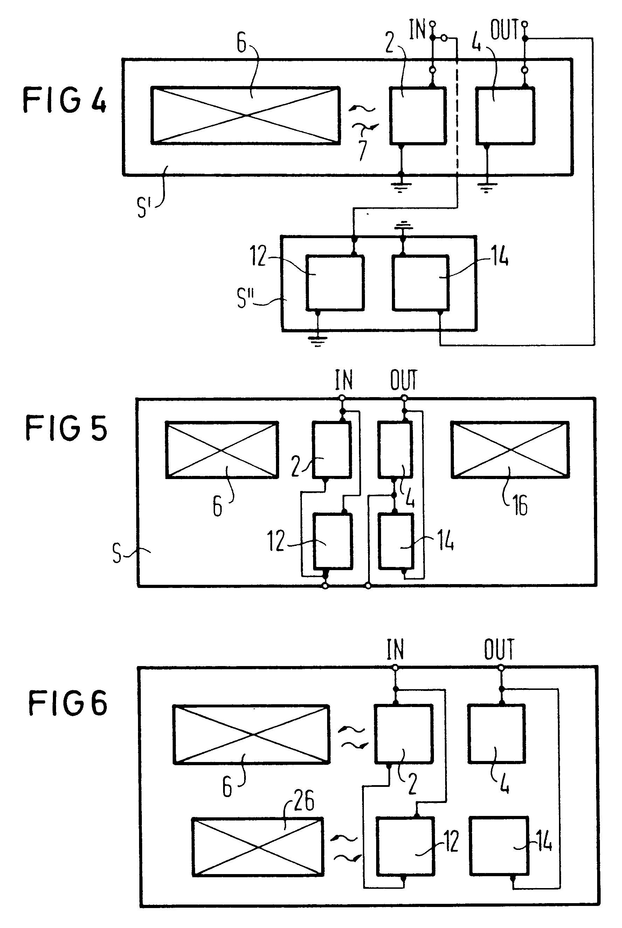

Fig. 4 zeigt ein Prinzipbild eines erfindungsgemäßen Filters, bei dem sich die Anordnung der Wandler 12 und 14 auf einem Substrat S˝ befindet, das getrennt ist vom Substrat S′ der Anordnung mit den Strukturen 2, 4 und 6. Die Phasenbeziehungen und die elektrischen Verbindungen sind auch für die Ausführungsform nach Fig. 4 in der beschriebenen Weise einzuhalten, um das erfindungsgemäße Ergebnis der Auslöschung des Übersprechens durch phasenentgegengesetzte Überlagerung zu erzielen.

Fig. 5 zeigt wiederum lediglich dem Prinzip nach eine Anordnung mit den Strukturen 2, 4, 6, 12 und 14 und zusätzlich mit einer weiteren Reflektorstruktur 16. Die erfindungsgemäß vorgesehene Kompensation des Übersprechens erfolgt wiederum zwischen den Strukturen 2 und 4 einerseits und 12 und 14 andererseits. Der Vorteil einer Ausführungsform nach Fig. 5 ist, daß die Verluste in der mit Reflektoren versehenen Spur minimiert sind, weil die nach beiden Seiten vom Eingangswandler 2 ausgesandten akustischen Wellen über die Reflektorstrukturen 6 und 16 in den Ausgangswandler 4 gelangen. Ein Filter nach Fig. 5 erfordert aber eine größere Länge, nämlich entsprechend der Länge der zusätzlichen Reflektorstruktur 16. Außerdem müssen die Wandler angepaßt sein, um Resonanzen zu vermeiden.

Eine Weiterbildung der Erfindung zeigt die Fig. 6. Von der Fig. 1 unterscheidet sich die Ausführung nach Fig. 4 darin, daß anstelle des Sumpfes 8 eine weitere Reflektorstruktur 26 vorgesehen ist. Die Reflektorstrukturen 6 und 26 müssen z. B. nicht notwendigerweise identische Strukturen sein. Sind sie unterschiedlich gewählt, kann man damit z.B. auch disjunkte Frequenzbereiche realisieren. Da bei dieser Ausführungsform nach Fig. 6 erfindungsgemäß die Wandler 2 und 4 einerseits und 12 und 14 andererseits entsprechend den obigen Vorschriften identische Struktur und entsprechende Anordnung bzw. entsprechendes Zusammenschalten aufweisen müssen, ist auch mit einer Ausführung nach Fig. 6 die aufgabengemäße Kompensation des direken Übersprechens zwischen Eingangswandler und Ausgangswandler zu erreichen. Zu beachten ist aber, daß das mit Reflexion im Reflektor 26 im Ausgangswandler 14 auftretende Filtersignal zusammen mit dem Filtersignal des Wandlers 4 nicht Auslöschung erfährt, weil die Phasenbeziehungen der Wandler 2/4 einerseits und der Wandler 12/14 bzw. 12/14′ andererseits erfindungsgemäß gewählt sind. Z.B. wählt man die Abstände zwischen dem Wandler 2 und der Reflektorstruktur 6 einerseits und den Strukturen 12/26 andererseits so, daß phasengleiche Empfangssignale auftreten.

Um ein besonders verlustarmes Filter zu erzielen, kann man die Wandler als unidirektional arbeitende Wandler ausbilden, die die akustische Oberfläche nur in Richtung auf den jeweils zugeordneten Reflektor abstrahlen. Dazu können aus dem Stand der Technik bekannte Unidirektionalwandler Verwendung finden.

Voranstehend ist für die Wandler 2 und 12 angenommen, daß sie die Eingangswandler sind. Die Funktionen "Eingangswandler" und "Ausgangswandler" können sinngemäß auch vertauscht sein. Wichtig ist die zueinander phasenentgegengesetzt auftretenden (gleichgroßen) Signale des direkten akustischen Signalübergangs, die sich gegenseitig aufheben.

## Patentansprüche

1. Oberflächenwellenfilter mit nur über Reflektor erfolgender Nutzsignalübertragung mit Substrat,
mit einem Eingangswandler (2) und mit einem Ausgangswandler (4), mit mindestens einem Reflektor (6) und mit durch den Reflektor bzw. die Reflektoren bewirkter 180°-Ablenkung der Oberflächenwelle (7) auf dem Weg (E/A) zwischen Eingangswandler und Ausgangswandler,
**gekennzeichnet dadurch,**
daß die 180°-Ablenkung durch jeweils ein- und demselben Reflektor (6,16) bewirkt ist,
daß zwei voneinander getrennte Hauptausbreitungsspuren (E/A) für zwei voneinander getrennte Oberflächenwellen vorgesehen sind,
daß zu jeder Hauptausbreitungsspur ein solches jeweiliges Wandlersystem (2/4; 12/14) mit einem Eingangswandler und einem Ausgangswandler vorgesehen ist, bei denen die Eingangswandler (2/12) einerseits und die Ausgangswandler (4/14) andererseits miteinander identische Strukturen sind und
daß die elektrischen Anschlüsse der Eingangswandler einerseits und die der Ausgangswandler andererseits derart miteinander verbunden sind, daß die im jeweiligen der beiden Wandlersysteme (2/4; 12/14) auf direktem akustischem Wege zwischen Eingangswandler und Ausgangswandler übertragenen Signale in den zusammengeschalteten Ausgangsanschlüssen der Ausgangswandler wenigstens nahezu phasenentgegengesetzt vorliegen.

2. Oberflächenwellenfilter nach Anspruch 1,
**gekennzeichnet dadurch,**
daß der Phasenunterschied durch entgegengesetzte Polung der Anschlüsse der beiden Ausgangswandler (4/14) der beiden Wandlersysteme erreicht ist.

3. Oberflächenwellenfilter nach Anspruch 1,
**gekennzeichnet dadurch**,
daß der Phasenunterschied durch entgegengesetzte Polung der Anschlüsse der beiden Eingangswandler (2/12) der beiden Wandlersysteme erreicht ist.

4. Oberflächenwellenfilter nach Anspruch 1,
**gekennzeichnet dadurch,**
daß der Phasenunterschied durch zueinander phasenentgegengesetztes Einandergegenüberstellen von Eingangswandler und Ausgangswandler innerhalb der Wandlersysteme (2/4; 12/14) erzielt ist.

5. Oberflächenwellenfilter nach Anspruch 1 oder 4,
**gekennzeichnet dadurch,**
daß phasenentgegengesetztes Ausgangssignal durch einen um ein ungeradzahliges Vielfaches der halben Wellenlänge Lambda unterschiedlichen Abstand vom Eingangswandler zum Ausgangswandler der Wandlersysteme (2/4; 12/14) erzielt ist.

6. Oberflächenwellenfilter nach einem der Ansprüche 1 bis 5,
**gekennzeichnet dadurch**,
daß die Spur mit einem ersten Reflektor (6) einen weiteren Reflektor (16), in-line-angeordnet, auf der anderen Seite des Wandlersystems (2/4) hat.

7. Oberflächenwellenfilter nach einem der Ansprüche 1 bis 6,
**gekennzeichnet dadurch,**
daß in der zweiten Hauptausbreitungsspur ebenfalls eine Reflektorstruktur (26) vorgesehen ist.

8. Oberflächenwellenfilter nach einem der Ansprüche 1 bis 7,
**gekennzeichnet dadurch**,
daß die beiden Hauptausbreitungsspuren sich auf zwei voneinander getrennten Substraten befinden.

## Claims

1. Surface wave filter with wanted signal transmission with substrate effected only by means of reflectors, having an input transducer (2) and having an output transducer (4), with at least one reflector (6) and with 180° deflection of the surface wave (7) on the path (E/A) between input transducer and output transducer brought about by the reflector or the reflectors, characterized in that the 180° deflection is brought about by in each case one and the same reflector (6, 16), in that two mutually separate main propagation tracks (E/A) are provided for two mutually separate surface waves, in that such a respective transducer system (2/4; 12/14) having an input transducer and an output transducer is provided for each main propagation track, in which the input transducers (2/12) on the one hand and the output transducers (4/14) on the other hand have structures identical to one another, and in that the electrical terminals of the input transducers on the one hand and those of the output transducers on the other hand are connected to one another in such a way that the signals transmitted in the respective one of the two transducer systems (2/4; 12/14) on the direct acoustic path between input transducer and output transducer are present with at least approximate phase opposition in the connected output terminals of the output transducers.

2. Surface wave filter according to Claim 1, characterized in that the phase difference is achieved by the terminals of the two output transducers (4/14) of the two transducer systems having opposite polarity.

3. Surface wave filter according to Claim 1, characterized in that the phase difference is achieved by the terminals of the two input transducers (2/12) of the two transducer systems having opposite polarity.

4. Surface wave filter according to Claim 1, characterized in that the phase difference is achieved by input transducer and output transducer within the transducer systems (2/4; 12/14) having mutually opposite phase.

5. Surface wave filter according to Claim 1 or 4, characterized in that the phase-opposed output signal is achieved by a distance from the input transducer to the output transducer of the transducer systems (2/4; 12/14) which differs by an uneven multiple of half the wavelength lambda.

6. Surface wave filter according to one of Claims 1 to 5, characterized in that the track with a first reflector (6) has a further reflector (16), arranged in-line, on the other side of the transducer system (2/4).

7. Surface wave filter according to one of Claims 1 to 6, characterized in that a reflector structure (26) is likewise provided in the second main propagation track.

8. Surface wave filter according to one of Claims 1 to 7, characterized in that the two main propagation tracks are located on two mutually separate substrates.

## Revendications

1. Filtre d'ondes de surface, dans lequel la transmission du signal utile s'effectue uniquement par l'intermédiaire d'un réflecteur à substrat et qui comporte,
un transducteur d'entrée (2) et un transducteur de sortie (4), au moins un réflecteur (6), avec une déviation sur 180°, provoquée par le ou les réflecteurs, de l'onde de surface (7) sur le trajet (E/A) entre le transducteur d'entrée et le transducteur de sortie,
caractérisé par le fait
que la déviation à 120° est produite respectivement par un seul et même réflecteur (6, 16),
qu'il est prévu deux pistes de propagation principales (E/A) distinctes l'une de l'autre, pour deux ondes de surface distinctes l'une de l'autre,
que pour chaque piste de propagation principale, il est prévu un tel système de transducteurs (2/4; 12/14) comportant un transducteur d'entrée et un transducteur de sortie dans lesquels, les transducteurs d'entrée (2/12) d'une part et les transducteurs de sortie (4/14) d'autre part sont des structures identiques, et
que les bornes électriques des transducteurs d'entrée d'une part et les bornes électriques des transducteurs de sortie d'autre part sont reliées entre elles de telle sorte que des signaux, qui sont transmis dans les deux systèmes de transducteurs (2/4; 12/14) selon un trajet acoustique direct entre le transducteur d'entrée et le transducteur de sortie, sont présents au moins presque en opposition de phase dans les bornes de sortie interconnectées des transducteurs de sortie.

2. Filtre d'ondes de surface suivant la revendication 1, caractérisé par le fait que la différence de phase est obtenue au moyen d'une polarisation opposée des bornes des deux transducteurs de sortie (4/14) des deux systèmes de transducteurs.

3. Filtre d'ondes de surface suivant la revendication 1, caractérisé par le fait que la différence de phase est obtenue au moyen d'une polarisation opposée des bornes des deux transducteurs d'entrée (2/12) des deux systèmes de transducteurs.

4. Filtre d'ondes de surface suivant la revendication 1, caractérisé par le fait que la différence de phase est obtenue en mettant en place réciproquement en vis-à-vis et en opposition de phase, un transducteur d'entrée et un transducteur de sortie à l'intérieur des systèmes de transducteurs (2/4; 12/14).

5. Filtre d'ondes de surface suivant la revendication 1 ou 4, caractérisé par le fait que le signal de sortie de phase opposée est obtenu grâce au choix d'une distance, qui diffère d'un multiple impair de la demi-longueur d'onde, entre le transducteur d'entrée et le transducteur de sortie des systèmes de transducteurs (2/4; 12/14).

6. Filtre d'ondes de surface suivant l'une des revendications 1 à 5, caractérisé par le fait que la piste pourvue d'un premier réflecteur (6) comporte un autre réflecteur (16) disposé en ligne, de l'autre côté du système de transducteurs (2/4).

7. Filtre d'ondes de surface suivant l'une des revendications 1 à 6, caractérisé par le fait qu'une structure de réflecteur (26) est également prévue sur la seconde piste de propagation principale.

8. Filtre d'ondes de surface suivant l'une des revendications 1 à 7, caractérisé par le fait que les deux pistes de propagation principales sont situées sur deux substrats indépendants l'un de l'autre.
